(19) Europäisches Patentamt
European Patent Office
Office européen des brevets

(11) **EP 3 831 979 B1**

(12) **EUROPEAN PATENT SPECIFICATION**

(45) Date of publication and mention of the grant of the patent:
**16.10.2024 Bulletin 2024/42**

(21) Application number: **19860343.3**

(22) Date of filing: **19.08.2019**

(51) International Patent Classification (IPC):
***C23C 16/448*** *(2006.01)*     ***C23C 16/458*** *(2006.01)*

(52) Cooperative Patent Classification (CPC):
**C23C 16/4488; C23C 16/458**

(86) International application number:
**PCT/JP2019/032303**

(87) International publication number:
**WO 2020/054328 (19.03.2020 Gazette 2020/12)**

(54) **HOT FILAMENT CVD DEVICE**

CVD-HEISSFILAMENTVORRICHTUNG

DISPOSITIF DE DÉPÔT CHIMIQUE EN PHASE VAPEUR À FILAMENT CHAUD

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.09.2018 JP 2018168448**

(43) Date of publication of application:
**09.06.2021 Bulletin 2021/23**

(73) Proprietor: **KABUSHIKI KAISHA KOBE SEIKO SHO (KOBE STEEL, LTD.)**
**Hyogo 651-8585 (JP)**

(72) Inventors:
• **TAKAHASHI, Tetsuya**
**Takasago-shi, Hyogo 676-8670 (JP)**

• **HIROTA, Satoshi**
**Takasago-shi, Hyogo 676-8670 (JP)**
• **CREMER, Rainer**
**52156 Monschau (DE)**

(74) Representative: **TBK**
**Bavariaring 4-6**
**80336 München (DE)**

(56) References cited:
**WO-A1-2015/163470      CN-A- 106 167 894**
**JP-A- 2011 122 232      JP-A- 2018 511 702**
**US-A1- 2014 102 364      US-A1- 2018 105 935**

EP 3 831 979 B1

## Description

### Technical Field

The present invention relates to a hot filament CVD device that forms a coating film on a base material.

### Background Art

Known examples of a coating device for forming a coating film such as a diamond thin film on a surface of a base material include a hot filament CVD device. In such a hot filament CVD device, a mixed gas of hydrocarbons (methane) and hydrogen is preheated by a filament heated to 1000 degrees or more, and the heated gas is introduced into the surface of the substrate to deposit diamond due to thermal decomposition of the hydrocarbons.

JP H04 6274 A discloses a technique in which a workpiece (base material) is disposed inside a filament wound in a cylindrical shape to deposit a uniform diamond film on a surface of the workpiece having a three-dimensional shape. The technique uses a structural member including multiple struts and a beam in the shape of a ring connecting the multiple struts. A single filament is stretched around the struts and the beam of the structural member to form a heating region in a cylindrical shape.

In the technique described in JP H04 6274 A, the base material (workpiece) is disposed inside the heating region in a cylindrical shape at the time of coating treatment. In such a structure, it is difficult to dispose multiple base materials in the heating region in a cylindrical shape for the purpose of improving coating treatment efficiency. When the base materials are each a heavy object such as a cemented carbide tool, there is a problem in that a large amount of time is required for preparatory work for disposing the multiple base materials in the heating region.

CN 106 167 894 A discloses a hot filament CVD device as specified in the preamble of claim 1. In the technique described in CN 106 167 894 A, a movable platform is inserted into a chamber including a chamber body provided with an opening. The movable platform includes a flange plate assembly for sealing the opening, a water-cooled platform, multiple hot filaments to be disposed together with the water-cooled platform inside the chamber, and multiple fixing blocks mounted on the water-cooled platform to support multiple base materials.

### Summary of Invention

It is an object of the present invention to provide a hot filament CVD device capable of easily disposing multiple base materials in a chamber.

The present invention provides a hot filament CVD device as specified in claim 1.

## Brief Description of Drawings

FIG. 1 is a perspective view of a hot filament CVD device according to an embodiment of the present invention.

FIG. 2 is a perspective view illustrating an internal structure of the hot filament CVD device according to the embodiment of the present invention.

FIG. 3 is a front view illustrating the internal structure of the hot filament CVD device according to the embodiment of the present invention.

FIG. 4 is a plan view illustrating the internal structure of the hot filament CVD device according to the embodiment of the present invention.

FIG. 5 is an electrical block diagram of the hot filament CVD device according to the embodiment of the present invention.

FIG. 6 is a perspective view of multiple filament cartridges of the hot filament CVD device according to the embodiment of the present invention.

FIG. 7 is a perspective view of multiple filament cartridges of the hot filament CVD device according to the embodiment of the present invention.

FIG. 8 is a sectional view of a connecting member of the filament cartridge according to the embodiment of the present invention.

FIG. 9 is a front view illustrating the internal structure of the hot filament CVD device according to the embodiment of the present invention, and is a front view of a state in which the filament cartridge is detached.

FIG. 10 is a perspective view illustrating the internal structure of the hot filament CVD device according to the embodiment of the present invention, and is a perspective view illustrating a state in which the filament cartridge is attached.

FIG. 11 is a perspective view illustrating the internal structure of the hot filament CVD device according to the embodiment of the present invention, and is a perspective view of a state in which the filament cartridge is attached.

FIG. 12 is a sectional view of a holding part of the hot filament CVD device according to the embodiment of the present invention.

FIG. 13 is a sectional view of a state in which the filament cartridge is supported by the holding part of the hot filament CVD device according to the embodiment of the present invention.

FIG. 14 is a perspective view illustrating the internal structure of the hot filament CVD device according to the embodiment of the present invention, and is a perspective view illustrating a state of mounting a base material support.

FIG. 15 is a plan view illustrating the internal structure of the hot filament CVD device according to the embodiment of the present invention, and is a plan view illustrating a state of mounting the base material support.

FIG. 16 is a front view illustrating the internal structure of the hot filament CVD device according to the embodiment of the present invention, and is a front view illustrating a state of raising a stage.

FIG. 17 is a perspective view illustrating the internal structure of the hot filament CVD device according to the embodiment of the present invention, and is a perspective view illustrating a state in which the stage is raised.

FIG. 18 is a front view illustrating the internal structure of the hot filament CVD device according to the embodiment of the present invention, and is a front view illustrating a state in which the stage is raised.

**Description of Embodiment**

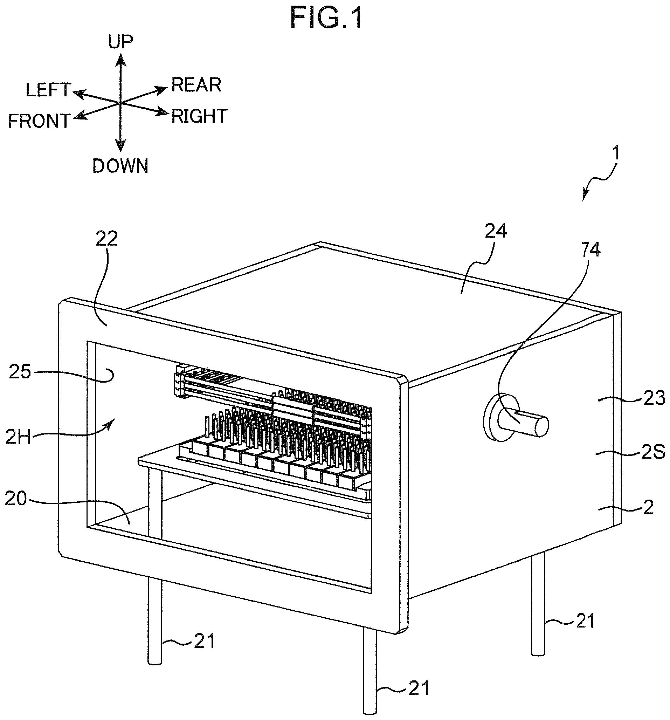

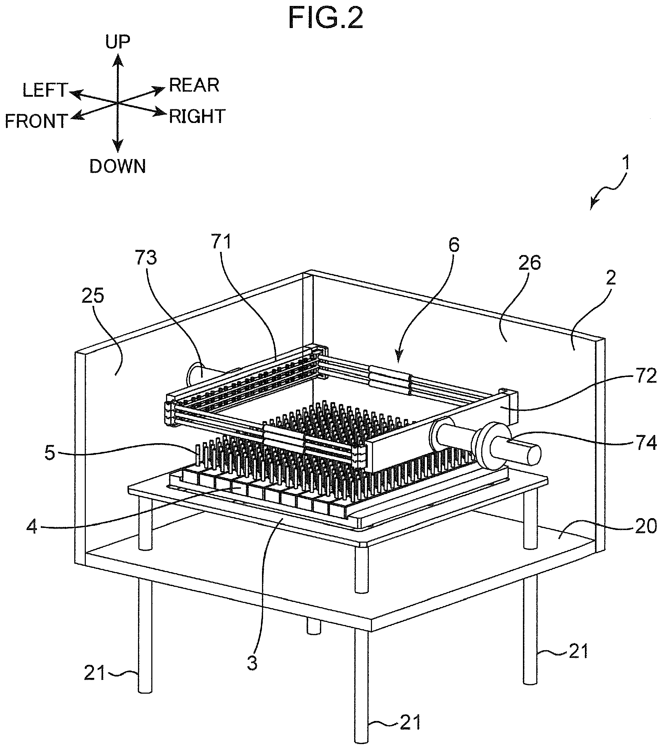

Hereinafter, a hot filament CVD device 1 according to an embodiment of the present invention will be described with reference to the drawings. FIG. 1 is a perspective view of the hot filament CVD device 1 according to the present embodiment. FIGS. 2 to 4 are respectively a perspective view, a front view, and a plan view, illustrating the internal structure of the hot filament CVD device 1. FIG. 2 illustrates a chamber 2 described later that is partially eliminated.

The hot filament CVD device 1 performs coating treatment on multiple workpieces 5 (base materials). The workpieces 5, for example, are each a drill blade in the present embodiment. As a material of each of the workpieces 5, cemented carbide is typically used. A hot filament CVD method is for forming a thin film using a product of thermal decomposition or a chemical reaction. The hot filament CVD method is a type of chemical vapor deposition (CVD) and uses a decomposition product or a chemical reaction of a material gas due to thermal energy emitted by a filament. The hot filament CVD device 1 can be suitably used for forming a carbon-based thin film, particularly a diamond thin film (polycrystalline diamond thin film). In the present embodiment, the hot filament CVD device 1 forms a diamond thin film on a surface of each of the workpieces 5 by the hot filament CVD method. As a material gas for forming such a diamond thin film, a mixed gas is used in which a carbon compound gas such as a hydrocarbon and a hydrogen gas are mixed. In the present embodiment, a mixed gas composed of 1% methane and 99% hydrogen by volume is used.

The hot filament CVD device 1 includes the chamber 2 having an internal space. The chamber 2 has a chamber body 2S and a door (not illustrated). The chamber body 2S defines the above internal space. The chamber body 2S includes a bottom 20, four (multiple) legs 21, a front flange 22, a right wall 23, a top plate 24, a left wall 25, and a rear wall 26 (FIGS. 1 and 2). The front flange 22 is provided with an opening 2H. The door (not illustrated) is attached to the chamber body 2S in an openable and closable manner. The door, when closed, seals the opening 2H. The door, when opened, opens the opening 2H. The four legs 21 each have a lower end extended downward from the bottom 20. Each of the legs 21 has an air cylinder structure and can be extended and contracted. Each of the legs 21 has an upper end that is disposed inside the chamber 2 and connected to a stage 3 described later. The internal space of the chamber 2 communicates with a vacuum pump (not illustrated) to cause the internal space of the chamber 2 to be in a vacuum or a substantially vacuum state during the coating treatment.

The hot filament CVD device 1 further includes the stage 3, multiple workpiece support blocks 4 (base material supports) for supporting the respective multiple workpieces 5, a filament electrode unit 6 (filament unit), a fixed electrode 71, a movable electrode 72, a left support 73, and a right support 74.

The stage 3 is disposed horizontally inside the chamber 2 and supports the multiple workpiece support blocks 4. The stage 3 has a rectangular shape in plan view, and the legs 21 described above are connected to four corners of a lower surface of the stage 3. When each of the legs 21 is extended and contracted by a stage drive unit 83 described later, the stage 3 moves up and down inside the chamber 2. The stage 3 includes a table 31 in a rectangular shape in top view. The table 31 is formed with a fixing portion 31S in a recessed shape to allow the multiple workpiece support blocks 4 to be disposed without gaps in the left-right direction.

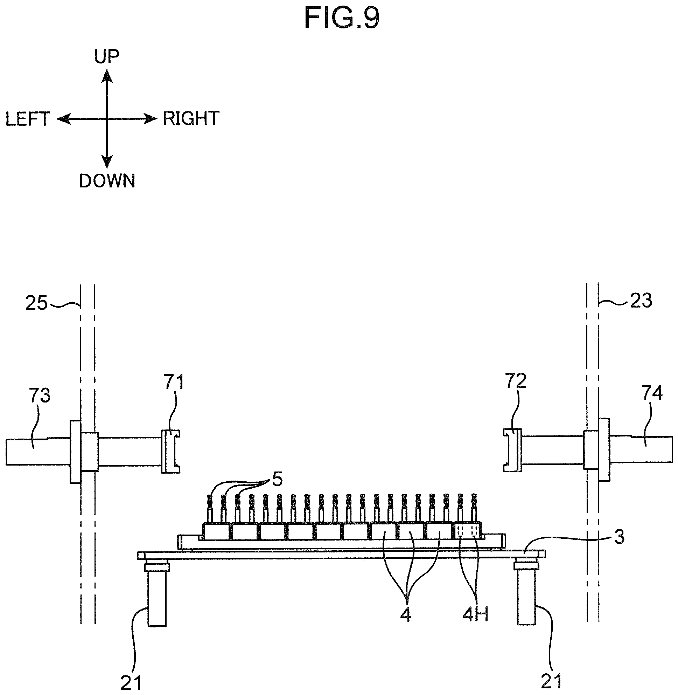

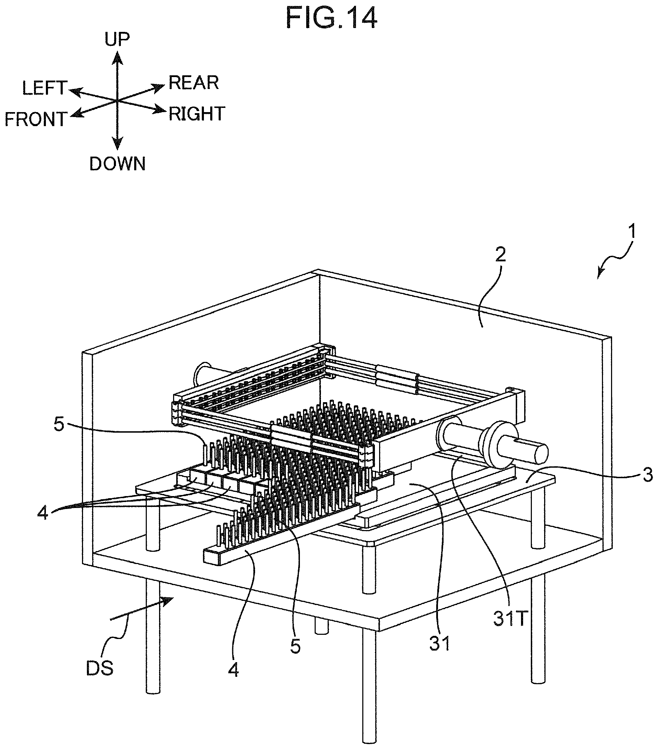

Each of the multiple workpiece support blocks 4 has a rectangular parallelepiped shape (strip shape) elongated in a front-rear direction. Each of the multiple workpiece support blocks 4 can be inserted into the chamber 2 through the opening 2H of the chamber 2 in the insertion direction (refer to arrow DS in FIG. 14). Each of the workpiece support blocks 4 has multiple support holes 4H (refer to FIG. 9) (holes, base material holding parts), which are opened (formed) in its upper surface and into each of which a workpiece 5 can be inserted in a vertical direction and can be held. Specifically, each of the workpiece support blocks 4 is provided with two rows of groups of the multiple support holes 4H at an interval in the left-right direction, and each of the groups of multiple support holes 4H includes the multiple support holes 4H disposed at intervals in the front-rear direction. At this time, the intervals in the front-rear direction of the multiple support holes 4H are set evenly. As a result, the multiple workpiece support blocks 4 support the corresponding multiple workpieces 5 so that the multiple workpieces 5 are disposed at intervals in the insertion direction.

The table 31 described above has a mounting surface that allows the multiple workpiece support blocks 4 to be mounted allowing the multiple workpieces 5 to be disposed facing the corresponding multiple filaments 60. Then, the table 31 supports the multiple workpiece support blocks 4 so that the multiple workpiece support blocks 4 are disposed adjacent to each other in a chamber width direction (left-right direction in FIG. 14) intersecting a predetermined insertion direction (refer to arrow DS in FIG. 14) inside the chamber 2. In particular, in the present embodiment, the table 31 has a body part 31H having the mounting surface, a restriction portion 31T (standing wall), and paired side walls 31R. The restriction portion 31T restricts the multiple workpiece support blocks 4 in the insertion direction by being in contact with a leading end in the insertion direction of each of the multiple workpiece support blocks 4 mounted on the mounting surface of the table 31. The paired side walls 31R are in contact with respective side surfaces of paired workpiece support blocks 4 located at respective opposite ends in the left-right direction among the multiple workpiece support blocks 4 mounted on the mounting surface of the table 31. Then a distance between the paired side walls 31R in the left-right direction is set so that the multiple workpiece support blocks 4 are brought into contact with each other in the left-right direction to restrict the multiple workpiece support blocks 4 in the left-right direction.

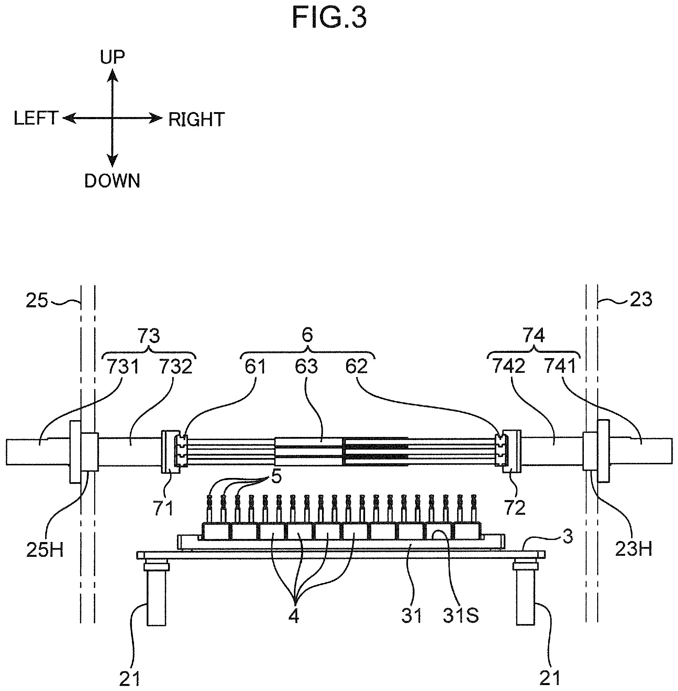

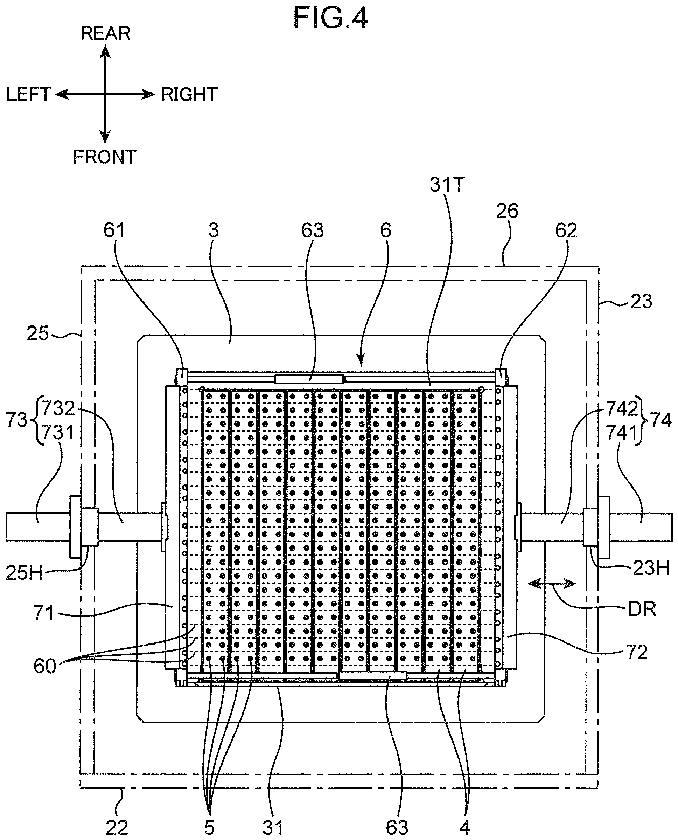

As illustrated in FIGS. 2 and 3, the filament electrode unit 6 is disposed above the stage 3 (multiple workpieces 5) inside the chamber 2. The filament electrode unit 6 includes multiple filaments 60 (FIG. 4). Structure of the filament electrode unit 6 will be described in more detail later.

The fixed electrode 71 and the movable electrode 72 are disposed inside the chamber 2. As illustrated in FIGS. 2 and 4, the fixed electrode 71 and the movable electrode 72 are disposed extending in the front-rear direction. The fixed electrode 71 is electrically connected to a left end (one end in a first direction) of each of the multiple filaments 60. In contrast, the movable electrode 72 is electrically connected to a right end (the other end in the first direction) of each of the multiple filaments 60. The fixed electrode 71 and the movable electrode 72 are electrically connected to a heating power source 81 described later. Upon receiving electric power of the heating power source 81, the fixed electrode 71 and the movable electrode 72 allow a predetermined current to flow between the left end and the right end of each of the multiple filaments 60. As a result, the multiple filaments 60 are heated.

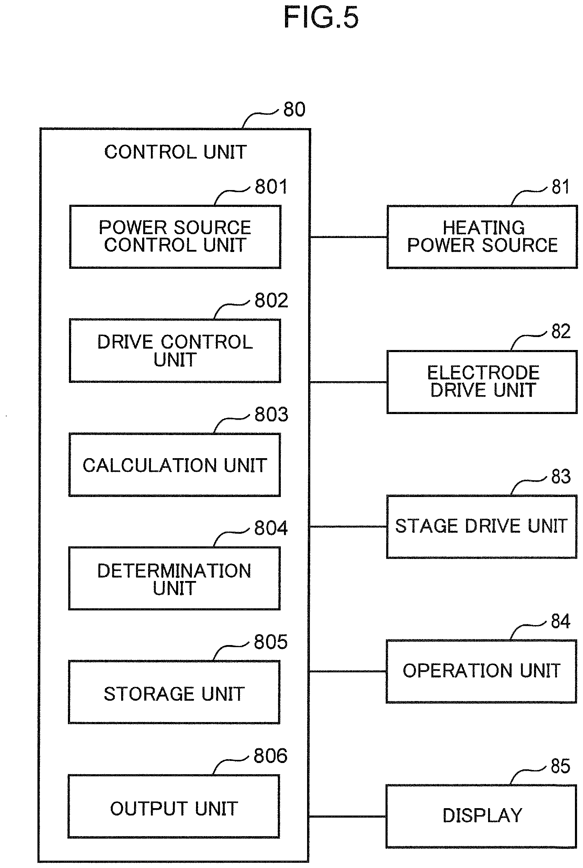

The left support 73 and the right support 74 support the fixed electrode 71 and the movable electrode 72, respectively. The left support 73 and the right support 74 electrically connect the heating power source 81 and the filament electrode unit 6. Thus, electrical wiring (not illustrated) is provided inside the left support 73 and the right support 74. The left support 73 includes a left outer support 731 exposed to the outside of the chamber 2 and a left inner support 732 located inside the chamber 2 (FIG. 3). Similarly, the right support 74 includes a right outer support 741 exposed to the outside of the chamber 2 and a right inner support 742 located inside the chamber 2. In the present embodiment, the right inner support 742 of the right support 74 includes an extendable cylinder structure. The right inner support 742 extends and contracts inside the chamber 2 in response to a driving force generated by an electrode drive unit 82 (FIG. 5) described later. As a result, the movable electrode 72 can be moved in the left-right direction inside the chamber 2 (refer to arrow DR in FIG. 4).

As illustrated in FIGS. 3 and 4, through holes 23H and 25H through which the left support 73 and the right support 74 pass are opened in the right side wall 23 and the left side wall 25 of the chamber 2, respectively. Gaps between the through holes and the corresponding supports are sealed with a sealing material (not illustrated). FIG. 5 is an electrical block diagram of the hot filament CVD device 1 according to the present embodiment. The hot filament CVD device 1 further includes a control unit 80. The control unit 80 comprehensively controls operation of the hot filament CVD device 1, and is electrically connected to transmission-reception destinations of a control signal, such as the heating power source 81, the electrode drive unit 82, the stage drive unit 83 (moving mechanism), an operation unit 84, and a display 85. The control unit 80 is also electrically connected to other units provided in the hot filament CVD device 1. The hot filament CVD device 1 also includes a control unit of a gas flow rate (not illustrated), and the like.

The heating power source 81 allows a predetermined current to flow through the fixed electrode 71 and the movable electrode 72 so that the multiple filaments 60 are heated to about 2000°C to 2500°C. For the heating power source 81, a high-frequency pulse power source having stable DC characteristics is desirably used.

The electrode drive unit 82 includes a motor and a gear mechanism (not illustrated). The electrode drive unit 82 generates a driving force for moving the movable electrode 72 inside the chamber 2. The electrode drive unit 82 is connected to the right support 74.

The stage drive unit 83 includes a motor and a gear mechanism (not illustrated). The stage drive unit 83 generates a driving force for moving the stage 3 up and down inside the chamber 2. The stage drive unit 83 is connected to the four legs 21.

The operation unit 84 is formed of an operation panel (not illustrated) and accepts various operations for controlling the hot filament CVD device 1.

The display 85 is formed of a liquid crystal panel (not illustrated) and displays information on various movements of the hot filament CVD device 1, for example.

The control unit 80 is configured by a central processing unit (CPU), a read only memory (ROM) for storing a control program, a random access memory (RAM) used as a work area of the CPU, and the like, and operates to functionally include a power source control unit 801, a drive control unit 802, a calculation unit 803, a determination unit 804, a storage unit 805, and an output unit 806, when the CPU executes the control program.

The power source control unit 801 controls the heating power source 81 according to operation information input to the operation unit 84. The power source control unit 801 controls output (kW), heating time, and the like of the heating power source 81.

The drive control unit 802 causes the electrode drive unit 82 according to the operation information input to the operation unit 84 to move the movable electrode 72 to left and right. The drive control unit 802 causes the stage drive unit 83 according to the operation information input to the operation unit 84 to move the stage 3 up and down.

The calculation unit 803 calculates the amount of thermal expansion of the filaments 60 in accordance with heating time of the filaments 60. The calculation unit 803 also calculates the amount of movement setting of the movable electrode 72 based on the amount of thermal expansion.

The determination unit 804 determines disconnection of the filaments 60 based on change in a current value of the heating power source 81. When the determination unit 804 determines that the filament 60 is disconnected, information on the disconnection is displayed on the display 85.

The storage unit 805 stores various parameters, threshold information, and the like for controlling the hot filament CVD device 1. As an example, the storage unit 805 stores parameters for the calculation unit 803 to calculate the amount of thermal expansion of each of the filaments 60.

The output unit 806 outputs various command signals according to the control of the heating power source 81 and the electrode drive unit 82, being performed by the power source control unit 801 and the drive control unit 802.

<Structure of Filament Electrode Unit>

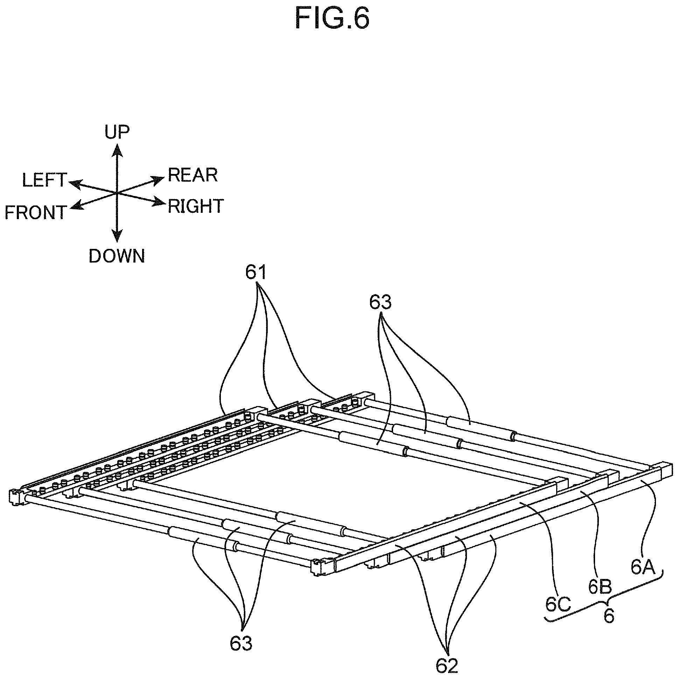

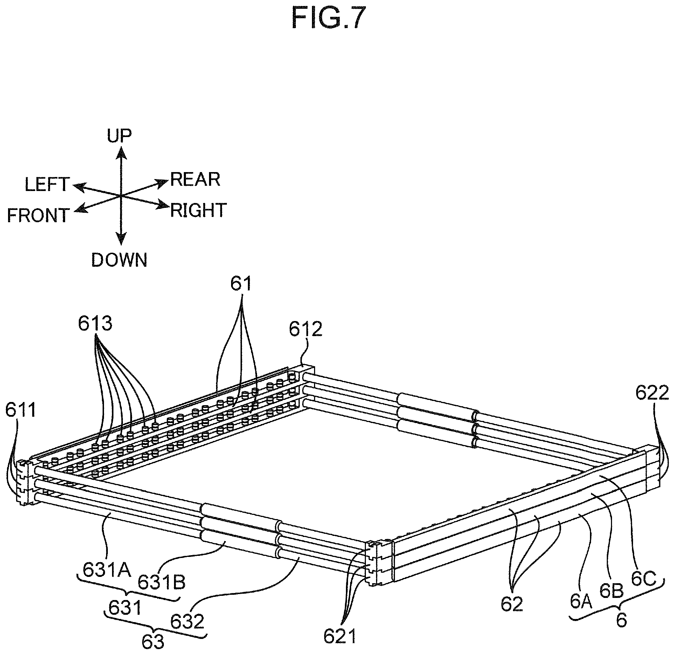

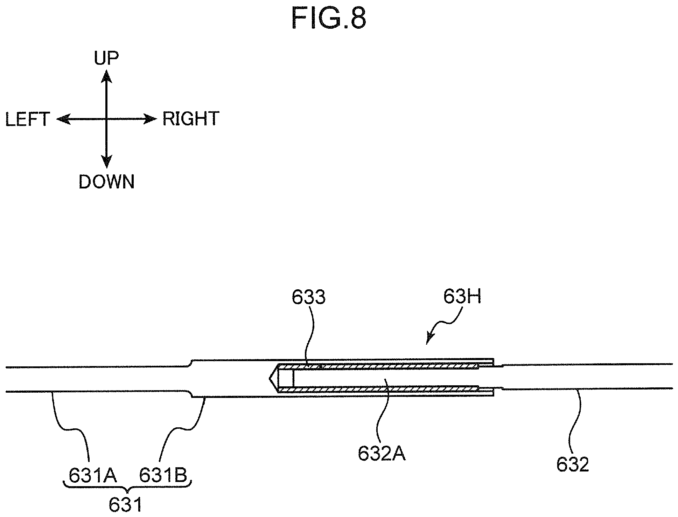

Next, structure of multiple filament cartridges according to the present embodiment will be described in more detail. FIGS. 6 and 7 are each a perspective view of the filament electrode unit 6 including the multiple cartridges according to the present embodiment. FIG. 8 is a sectional view of a connecting member 63 of the filament electrode unit 6.

In the present embodiment, the filament electrode unit 6 includes a first cartridge 6A, a second cartridge 6B, and a third cartridge 6C (multiple filament cartridges). The first cartridge 6A, the second cartridge 6B, and the third cartridge 6C each have the same structure. Each of the cartridges can be mounted inside the chamber 2 through the opening 2H (FIG. 1) with the door open. Hereinafter, the structure of the first cartridge 6A will be described as an example. The first cartridge 6A includes the multiple filaments 60, a left frame 61 (filament holding mechanism), a right frame 62 (filament holding mechanism), and paired connecting members 63. Each of the cartridges can be mounted in the chamber 2 even when it is flipped horizontally.

The multiple filaments 60 (FIG. 4) extend in the left-right direction (first direction) and are disposed apart from each other in the front-rear direction (second direction intersecting the first direction). For each of the filaments 60, a wire made of a refractory metal such as tungsten or tantalum, having a wire diameter of 0.05 mm to 1.0 mm, is used. Each of the filament cartridges is provided with 20 filaments 60.

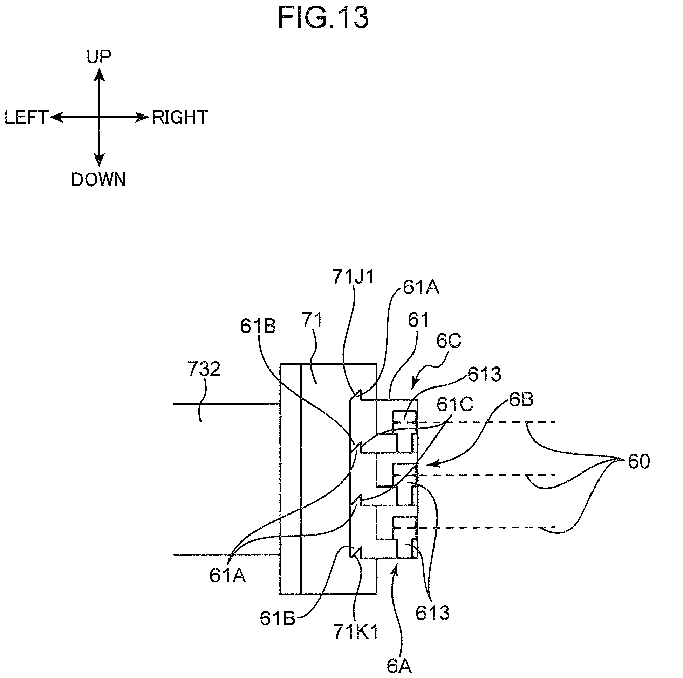

The left frame 61 is a member extending in the front-rear direction and supports left ends of the multiple filaments 60. The left frame 61 includes a left frame front end portion 611, a left frame rear end portion 612, and multiple filament engaging portions 613. The left frame front end portion 611 is disposed at a front end of the left frame 61 and supports a left end portion of the connecting member 63 on a front side. The left frame rear end portion 612 is disposed at a rear end of the left frame 61 and supports a left end portion of the connecting member 63 on a rear side. The multiple filament engaging portions 613 each engage a left end portion of the corresponding one of the filaments 60 (refer to FIG. 13). When the left frame 61 is supported by the fixed electrode 71, the left end portion of each of the filaments 60 and the heating power source 81 are electrically connected to each other through the corresponding one of the filament engaging portions 613.

Similarly, the right frame 62 is a member extending in the front-rear direction and supports right ends of the multiple filaments 60. The right frame 62 includes a right frame front end portion 621, a right frame rear end portion 622, and multiple filament engaging portions (not illustrated, similar to the filament engaging portions 613 described above). The right frame front end portion 621 is disposed at a front end of the right frame 62 and supports a right end portion of the connecting member 63 on the front side. The right frame rear end portion 622 is disposed at a rear end of the right frame 62 and supports a right end portion of the connecting member 63 on the rear side. The multiple filament engaging portions each engage a right end portion of the corresponding one of the filaments 60. When the right frame 62 is supported by the movable electrode 72, the right end portion of each of the filaments 60 and the heating power source 81 are electrically connected to each other through the corresponding one of the filament engaging portions.

The paired connecting members 63 connects respective opposite ends of the left frame 61 in the front-rear direction and corresponding opposite ends of the right frame 62 therein in the left-right direction. With reference to FIGS. 7 and 8, each of the connecting members 63 includes a first support rod 631 and a second support rod 632 that are made of metal, and an insulating bush 633. The first support rod 631 includes a small diameter portion 631A and a large diameter portion 631B. The second support rod 632 includes a leading end portion 632A. As illustrated in FIG. 8, the large diameter portion 631B of the first support rod 631 is formed with a cavity in a cylindrical shape. The insulating bush 633 has a cylindrical shape and is preliminarily fitted into the cavity of the large diameter portion 631B. As illustrated in FIG. 8, the leading end portion 632A of the second support rod 632 is inserted into the insulating bush 633 in the first support rod 631. The insulating bush 633 is made of an insulating material such as ceramic, and prevents electric discharge between the first support rod 631 and the second support rod 632. The insulating bush 633 has high slidability to the leading end portion 632A made of metal, and thus can reduce a drive load applied to the electrode drive unit 82 due to telescopic movement of each of the connecting members 63. As described above, when the movable electrode 72 is moved left and right using a driving force generated by the electrode drive unit 82, the right frame 62 and the pair of front and rear second support rods 632, being connected to the movable electrode 72, move following the movable electrode 72. At this time, the leading end portion 632A of each of the second support rods 632 slides inside the insulating bush 633. As described above, in the present embodiment, the first cartridge 6A, the second cartridge 6B, and the third cartridge 6C each hold the multiple filaments 60 in parallel, and each of the connecting members 63 can be extended and contracted in a direction in which the filaments 60 extend. The large diameter portion 631B of the first support rod 631 and the leading end portion 632A of the second support rod 632 constitute a telescopic portion 63H (FIG. 8) of the present invention. When receiving a driving force of the electrode drive unit 82 from the right support 74, the telescopic portion 63H extends and contracts allowing a change in distance between the left frame 61 and the right frame 62.

<Holding Part>

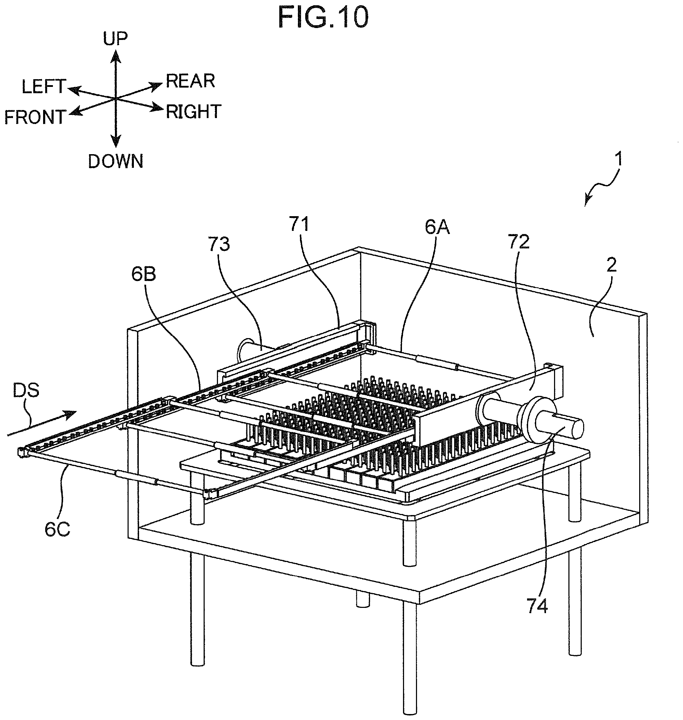

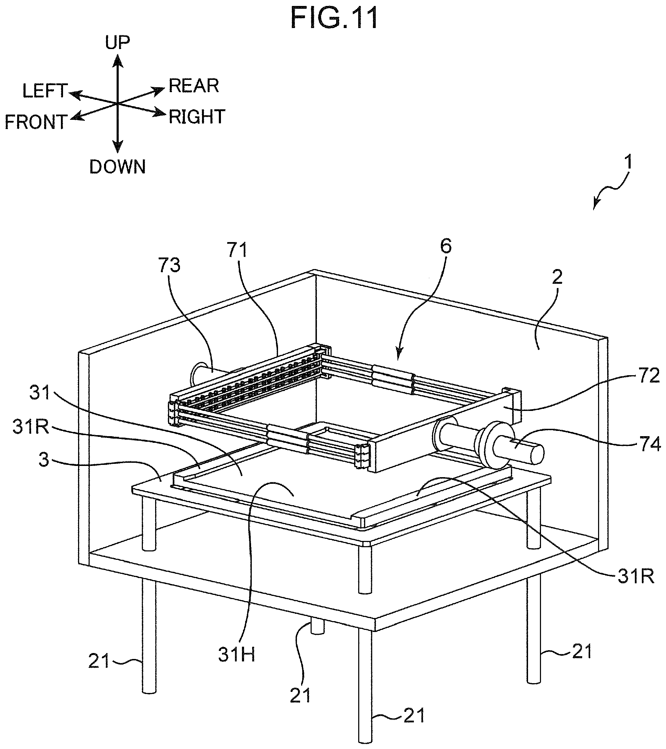

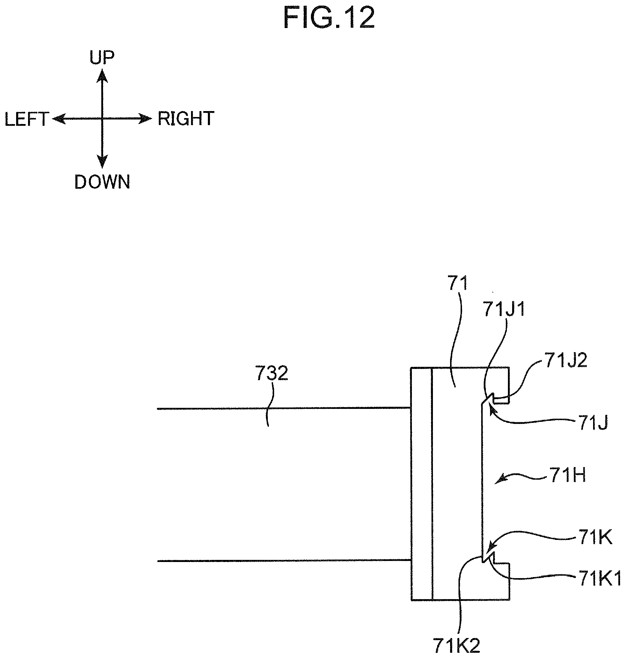

FIG. 9 is a front view illustrating an internal structure of the hot filament CVD device 1 according to the present embodiment, and is a front view of a state in which the filament electrode unit 6 is detached. FIG. 10 is a perspective view illustrating a state in which each cartridge of the filament electrode unit 6 is mounted on the fixed electrode 71 and the movable electrode 72. FIG. 11 is a perspective view illustrating a state in which each cartridge of the filament electrode unit 6 is held by the fixed electrode 71 and the movable electrode 72. FIG. 12 is a sectional view of the fixed electrode 71 of the hot filament CVD device 1, and FIG. 13 is a sectional view of a state in which each cartridge of the filament electrode unit 6 is held by the fixed electrode 71.

In the present embodiment, the fixed electrode 71 and the movable electrode 72 each include a holding part for holding the filament electrode unit 6. The fixed electrode 71 and the movable electrode 72 are bilaterally symmetrical in shape, so that the fixed electrode 71 will be described below as an example. As illustrated in FIG. 12, the fixed electrode 71 has a U-shape turned sideways, opening to the right, in section. In other words, the fixed electrode 71 includes an engaging recess 71H (holding part). The engaging recess 71H is formed throughout the fixed electrode 71 in the front-rear direction. The engaging recess 71H has an upper end portion formed with an electrode upper engaging portion 71J. The engaging recess 71H has a lower end portion formed with an electrode lower engaging portion 71K. The electrode upper engaging portion 71J has a triangular shape in section and is defined by an upper inclined portion 71J1 and an upper inner portion 71J2. Similarly, the electrode lower engaging portion 71K has a triangular shape in section and is defined by a lower inclined portion 71K1 and a lower inner portion 71K2. As illustrated in FIG. 12, the upper inclined portion 71J1 and the lower inclined portion 71K1 are parallel to each other and are inclined downward (to the left) toward the inside of the engaging recess 71H. Further, the fixed electrode 71 and the movable electrode 72 form a part of the filament holding mechanism of the present invention.

Then, with reference to FIG. 13, the left frame 61 of each of the first cartridge 6A, the second cartridge 6B, and the third cartridge 6C has a shape that can be fitted into the engaging recess 71H of the fixed electrode 71. That is, the left frame 61 has an upper left end portion formed with an upper protrusion 61A and a lower left end portion formed with a lower protrusion 61B. A lower recess 61C is formed on the right of the lower protrusion 61B. The upper protrusion 61A and the lower protrusion 61B have inclined surfaces that are respectively in contact with the upper inclined portion 7111 and the lower inclined portion 71K1 (FIG. 13).

A case will be described in which the first cartridge 6A, the second cartridge 6B, and the third cartridge 6C are combined overlapping each other in advance as illustrated in FIG. 7, and the filament electrode unit 6 is integrally attached to the fixed electrode 71 and the movable electrode 72. As illustrated in FIG. 13, when the upper protrusion 61A of the first cartridge 6A is fitted into the lower recess 61C of the second cartridge 6B, and the upper protrusion 61A of the second cartridge 6B is fitted into the lower recess 61C of the third cartridge 6C, the three cartridges are connected to each other. The same applies to the movable electrode 72 and the right frame 62. Then, the first cartridge 6A is inserted into the chamber 2 along the fixed electrode 71 while the lower protrusion 61B of the first cartridge 6A located at the lowermost position of the filament electrode unit 6 is fitted into the electrode lower engaging portion 71K (FIG. 12) of the fixed electrode 71. At this time, the right frame 62 of the first cartridge 6A is also inserted into the chamber along the movable electrode 72 using a similar structure. In contrast, the third cartridge 6C is inserted into the chamber 2 along the fixed electrode 71 while the upper protrusion 61A of the third cartridge 6C located at the uppermost position of the filament electrode unit 6 is fitted into the electrode upper engaging portion 71J (FIG. 12) of the fixed electrode 71. At this time, the right frame 62 of the third cartridge 6C is also inserted into the chamber along the movable electrode 72 using a similar structure. The first cartridge 6A, the second cartridge 6B, and the third cartridge 6C of the filament electrode unit 6 may be inserted into the chamber 2 in this order from below as illustrated in FIGS. 6 and 10.

As described above, in the present embodiment, the fixed electrode 71 and the movable electrode 72 each have a shape for guiding the first cartridge 6A, the second cartridge 6B, and the third cartridge 6C that are inserted into the internal space of the chamber 2 through the opening 2H in a mounting direction (arrow DS in FIG. 10) parallel to the front-rear direction. The fixed electrode 71 and the movable electrode 72 respectively hold the left frame 61 and the right frame 62 of each of the cartridges such that the multiple filaments 60 face the corresponding multiple workpieces 5 in the vertical direction (a third direction intersecting a plane including the first direction and the second direction) (FIGS. 3 and 4). Then, the multiple filaments 60 of each of the first cartridge 6A, the second cartridge 6B, and the third cartridge 6C mounted in the chamber 2 are disposed at intervals in the vertical direction. As a result, a space is formed between the filaments 60 adjacent to each other in the left-right direction, the space passing through the first cartridge 6A, the second cartridge 6B, and the third cartridge 6C in the vertical direction. At the time of the coating treatment, the workpieces 5 supported by the workpiece support blocks 4 are inserted into the space as described later.

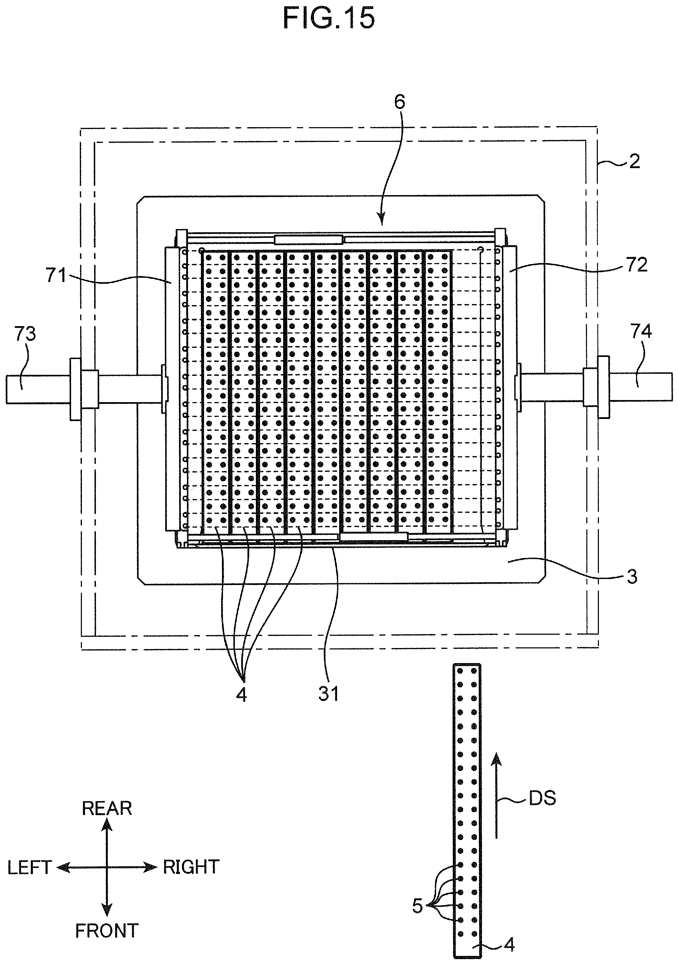

FIG. 14 is a perspective view illustrating an internal structure of the hot filament CVD device 1 according to the present embodiment, and is a perspective view illustrating a state of mounting the workpiece support blocks 4 on the stage 3. FIG. 15 is a plan view illustrating the internal structure of the hot filament CVD device 1, and is a plan view illustrating a state of mounting the workpiece support blocks 4 on the stage 3. As described above, the stage 3 includes the table 31. The table 31 is formed with the fixing portion 31S in a recessed shape (FIG. 3). The fixing portion 31S has a width in the left-right direction that corresponds to a length acquired by adding a slight gap fitting tolerance to the sum of widths of the multiple (10) workpiece support blocks 4 in the left-right direction. When each of the workpieces 5 is a drill blade, the drill blade has a heavy weight, and thus it is difficult to place many workpieces 5 on the table 31 at one time. In the present embodiment, as illustrated in FIGS. 14 and 15, the multiple workpiece support blocks 4 each have a rectangular parallelepiped shape extending in the front-rear direction, so that the multiple workpieces 5 (FIG. 15) distributed throughout the table 31 can be divided and placed on the table 31. The fixing portion 31S in a recessed shape has a function of positioning the multiple workpiece support blocks 4 in the left-right direction. The table 31 includes a restriction portion 31T (FIGS. 4 and 14) (standing wall) disposed at a rear end of the fixing portion 31S. The restriction portion 31T is a wall portion extending in the left-right direction, and regulates a rear end position of each of the workpiece support blocks 4 by being in contact with the multiple workpiece support blocks 4. As a result, positions of the multiple workpieces 5 supported on the corresponding multiple workpiece support blocks 4 in the front-rear and left-right directions are restricted. In other words, the multiple support holes 4H (FIG. 9) formed in each workpiece support block 4 are opened in the workpiece support block 4 such that the multiple workpieces 5 are disposed between the corresponding multiple filaments 60 of each cartridge of the filament electrode unit 6 held by the fixed electrode 71 and the movable electrode 72 when viewed from the vertical direction (third direction). Then, the fixing portion 31S of the table 31 restricts positions of the respective workpiece support blocks 4 such that the multiple workpieces 5 are disposed between the corresponding multiple filaments 60.

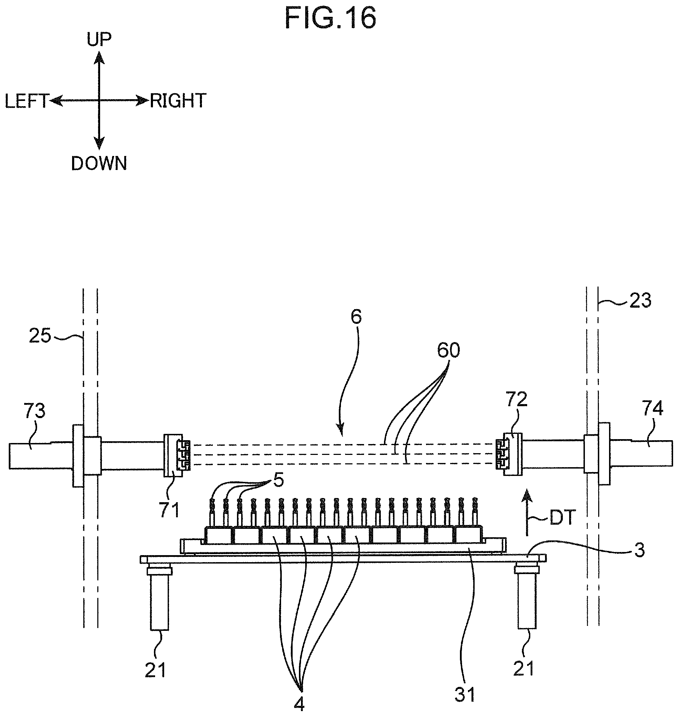

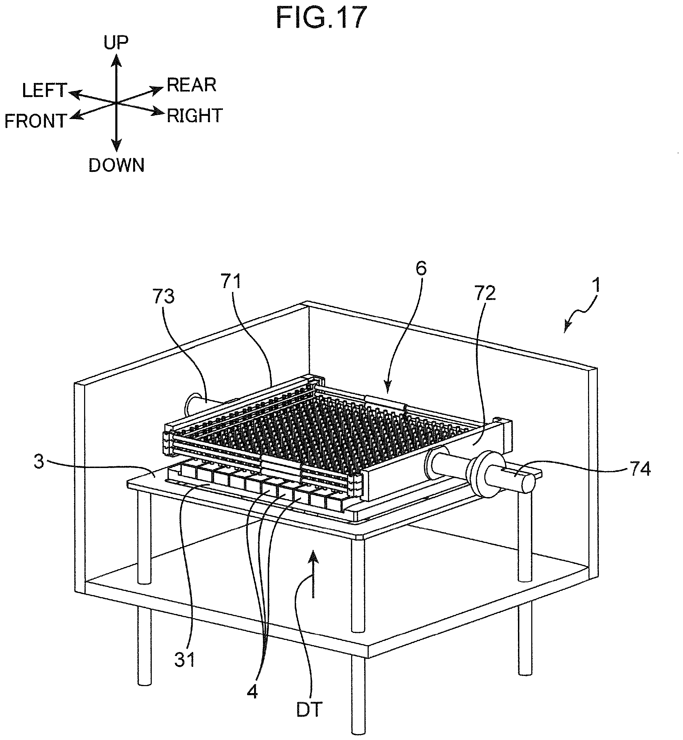

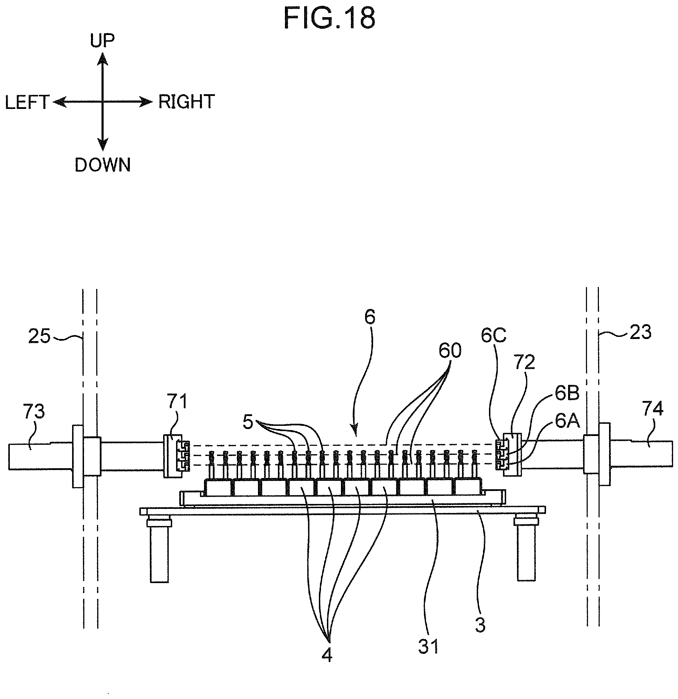

FIG. 16 is a front view illustrating the internal structure of the hot filament CVD device 1 according to the present embodiment, and is a front view illustrating a state of raising the table 31 (stage 3). FIG. 17 is a perspective view illustrating the internal structure of the hot filament CVD device 1, and is a perspective view illustrating a state in which the table 31 is raised. Further, FIG. 18 is a front view illustrating the internal structure of the hot filament CVD device 1, and is a front view illustrating a state in which the table 31 is raised.

As described above, the coating treatment to the multiple workpieces 5 is prepared such that the filament electrode unit 6 is mounted on the fixed electrode 71 and the movable electrode 72, and the multiple workpiece support blocks 4 supporting the corresponding multiple workpieces 5 are mounted on the table 31. When the door (not illustrated) is closed, the inside of the chamber 2 is evacuated by the vacuum pump and the mixed gas is introduced. When the operator operates the operation unit 84 (FIG. 5), the stage drive unit 83 moves the stage 3 upward (arrow DT in FIGS. 16 and 17). As a result, the multiple workpieces 5 are positioned between the corresponding multiple filaments 60 in a plane including the front-rear direction and the left-right direction. In the present embodiment, as illustrated in FIG. 18, upward movement of the stage 3 is controlled such that the tip of each of the workpieces 5 is located between the filament 60 of the third cartridge 6C and the filament 60 of the second cartridge 6B.

Next, when the power source control unit 801 causes the heating power source 81 to allow a current to flow into the fixed electrode 71 and the movable electrode 72 in response to operator's operation, heating of the multiple filaments 60 is started. Then, each of the filaments 60 thermally expands with the heating. In the present embodiment, the electrode drive unit 82 can move the movable electrode 72 in the left-right direction (extending direction of the filaments 60) as described above. The calculation unit 803 calculates the amount of thermal expansion $\Delta L$ (mm) of each of the filaments 60 from Equation 1.

$$\Delta L = \alpha \times (T2 - T1) \times L \ldots \quad \text{(Equation 1)}$$

In Equation 1, $\alpha$ is a coefficient of thermal expansion for each material, T1 is room temperature (°C), T2 is the temperature of the filaments 60 measured with a radiation thermometer, and L (mm) is an original length of each of the filaments 60.

Then, the drive control unit 802 causes the electrode drive unit 82 to move the movable electrode 72 to the right (in the direction of pulling the filaments 60) by the amount of thermal expansion calculated by the calculation unit 803. At this time, in the present embodiment, the movable electrode 72 is moved by the amount of thermal expansion of the filaments 60, so that no extra tension is applied to the filaments 60. As a result, a central portion of each of the filaments 60 is prevented from hanging downward (deforming) due to the thermal expansion of each of the filaments 60. Such movement control of the movable electrode 72 (attitude control of the filaments 60) is mainly performed in an initial stage of heating where the temperature of the filaments 60 rises. Such control may be continued throughout coating treatment time for the workpieces 5.

When each of the filaments 60 reaches a predetermined heating temperature in accordance with input power of the heating power source 81, the filaments 60 heat the material gas in the chamber 2, and then graphite and other non-diamond carbons react with atomic hydrogen and evaporate. Here, the atomic hydrogen reacts with an original hydrocarbon gas (methane) to form carbon-hydrogen species with high reactivity. When this species decomposes, hydrogen is released, pure carbon or diamond is formed, and a diamond film is formed on each of the workpieces 5.

As described above, in the present embodiment, the central portion of each of the filaments 60 is prevented from hanging downward during the coating treatment, so that a distance between each of the filaments 60 and the corresponding one of the workpieces 5 is prevented from varying in a longitudinal direction (left-right direction) of each of the filaments 60. This prevents fluctuation in deposition speed of each of the workpieces 5 and variation in deposition result (film thickness, uniformity) from occurring depending on a position on the table 31. When multiple filaments 60 are disposed adjacent to each other in the vertical and front-rear directions in the chamber 2 as in the present embodiment, direct measurement of temperature of each of the filaments 60 using a conventional radiation thermometer is likely to cause measurement accuracy to deteriorate. Additionally, each of the filaments 60 has a small diameter. This causes measurement of infrared rays and electromagnetic waves emitted to be difficult, and measuring equipment to be expensive. In contrast, in the present embodiment, the amount of thermal expansion of each of the filaments 60 is calculated in accordance with output power of the heating power source 81, and the movable electrode 72 is moved in accordance with the amount of the thermal expansion. Thus, as compared with a case where temperature of each of the filaments 60 is directly measured, control variation is reduced, an attitude of each of the filaments 60 is stably maintained, and coating quality for each of the workpieces 5 is improved.

As described above, in the present embodiment, the filament cartridges 6A, 6B and 6C supporting the multiple filaments 60 are inserted into the chamber 2 through the opening 2H. At this time, the fixed electrode 71 and the movable electrode 72 guide each of the filament cartridges, so that each of the filament cartridges can be easily inserted into the chamber 2. The fixed electrode 71 and the movable electrode 72 also hold each of the filament cartridges in the chamber 2 so that the multiple filaments 60 face the corresponding multiple workpieces 5. This enables each of the multiple filaments 60 to be easily disposed at a coating treatment position inside the chamber 2. Additionally, when a part of the multiple filaments 60 is broken, the broken filament 60 can be easily removed by replacing the corresponding filament cartridge.

In the present embodiment, multiple filament cartridges can be easily attached inside the chamber 2 and detached from inside the chamber 2. The filaments 60 of each of the multiple filament cartridges are disposed at intervals in the vertical direction, so that a coating treatment space in which each of the workpieces 5 is insertable can be formed between the filaments 60 adjacent to each other in the front-rear direction.

In the present embodiment, even when the multiple filaments 60 are thermally expanded during the coating treatment, hanging down or deformation of the multiple filaments 60 can be prevented by changing a distance between the left frame 61 and the right frame 62 using the electrode drive unit 82. Each of the paired connecting members 63 of each filament cartridge has the telescopic portion 63H, so that the above deformation due to thermal expansion can be prevented while cartridge structure of the multiple filaments 60 is maintained.

In the present embodiment, the multiple workpiece support blocks 4 supporting the corresponding multiple workpieces 5 can be inserted into the chamber 2 through the opening 2H. At this time, the operator can insert the multiple workpiece support blocks 4 in the predetermined insertion direction while sliding the workpiece support blocks 4 on the mounting surface of the table 31. Thus, even when each of the workpieces 5 is a heavy object, the multiple workpieces 5 can be easily disposed at respective coating treatment positions facing the corresponding multiple filaments 60 inside the chamber 2. The multiple workpiece support blocks 4 mounted on the mounting surface are disposed adjacent to each other in the left-right direction (chamber width direction). This enables the multiple workpieces 5 to be densely disposed inside the chamber 2.

In the present embodiment, when leading end portions of the respective multiple workpiece support blocks 4 come into contact with the restriction portion 3 1T, positions of the multiple workpiece support blocks 4 and also positions of the multiple workpieces 5 supported on the respective workpiece support blocks 4 in the insertion direction are restricted. When the multiple workpiece support blocks 4 are inserted in order, the workpiece support block 4 inserted earlier can guide the adjacent workpiece support block 4 to be inserted later. When all the workpiece support blocks 4 are inserted, positions of the multiple workpiece support blocks 4 and also positions of the multiple workpieces 5 supported on the respective workpiece support blocks 4 in the chamber width direction are restricted. As a result, the position of each of the workpieces 5 is restricted, so that the coating treatment on the workpieces 5 can be stably performed.

According to the present embodiment, the filament holding mechanism is provided, which holds the multiple filaments 60 so that the multiple filaments 60 extend in the first direction parallel to the insertion direction and are disposed apart from each other in the second direction intersecting the first direction, and face the corresponding multiple workpieces 5 in the third direction intersecting the plane including the first direction and the second direction inside the chamber 2. Another filament holding mechanism may be provided, which holds the multiple filaments 60 in the third direction intersecting the plane including the first direction and the second direction while allowing the multiple filaments 60 to face the corresponding multiple workpieces 5, wherein the multiple filaments 60 extend in the first direction intersecting the insertion direction and are disposed apart from each other in the second direction intersecting the first direction inside the chamber 2. According to these configurations, a plane including the multiple filaments 60 is disposed facing the multiple workpieces 5 in the vertical direction (third direction). This enables the coating treatment to be applied to the multiple workpieces 5 in a wide range.

In the present embodiment, when the workpieces 5 are inserted into the corresponding multiple support holes 4H of each of the workpiece support blocks 4, and the workpiece support blocks 4 are held on the table 31 of the stage 3, a coating treatment position of each of the workpieces 5 can be aligned with the corresponding one of the multiple filaments 60.

In the present embodiment, when the stage drive unit 83 moves the stage 3 including the table 31 in the vertical direction, the table 31 can be moved between the coating treatment position at which the multiple workpieces 5 are held at respective positions close to the corresponding multiple filaments 60, and a separation position at which the multiple workpieces 5 are held at respective positions further apart downward from the corresponding multiple filaments 60 than the coating treatment position.

Although the hot filament CVD device 1 according to an embodiment of the present invention has been described above, the present invention is not limited to the embodiment. As the hot filament CVD device according to the present invention, the following modified embodiments are applicable.

(1) Although the above embodiment is described in which the first cartridge 6A, the second cartridge 6B, and the third cartridge 6C are inserted into the chamber 2 in the front-rear direction (arrow DS in FIG. 10) intersecting (orthogonal to) a direction (left-right direction) in which the multiple filaments 60 extend, each of the cartridges may be inserted into the chamber 2 in the direction in which the multiple filaments 60 extend. In this case, the multiple filaments 60 extend in the front-rear direction in the chamber 2. The direction is parallel to a direction in which the multiple workpiece support blocks 4 are inserted. In this case, the fixed electrode 71 and the movable electrode 72 of FIG. 10 may be disposed on the front side and the rear side of the chamber 2, respectively. Any one of the electrodes to be disposed on the front side when each of the cartridges is attached or detached is desirably retracted downward or upward to prevent interference with attachment or detachment of each of the cartridges. The table 31 and each of the filament cartridges in the chamber 2 may be disposed in the vertical direction. That is, a structure in which the hot filament CVD device 1 in FIG. 1 is rotated 90 degrees around a horizontal axis may be used. The first cartridge 6A, the second cartridge 6B, and the third cartridge 6C may be each disposed with the filaments 60 each having a longitudinal direction intersecting (orthogonal to) a longitudinal direction of each of the workpiece support blocks 4.

(2) Although the above embodiment is described in which the fixed electrode 71 and the movable electrode 72 each include the holding part of the present invention, an electrode for applying voltage to the multiple filaments 60 may have another structure. In this case, paired holding parts each having an engaging recess 71H as in the above embodiment may be provided in the chamber 2, and voltage may be applied to each of the filaments 60 through a path different from the holding parts.

(3) Although the above embodiment is described in which the electrode drive unit 82 moves the movable electrode 72 in accordance with thermal expansion of the filaments 60, the present invention is not limited to this. The hot filament CVD device 1 may include only the cartridge structure of the filament electrode unit 6 without including a mechanism for moving the electrode (holding part). The workpiece support block 4 may be formed of one block placed on the table 31 without being divided into multiple blocks.

(4) Although the above embodiment is described in which when the movable electrode 72 is moved in accordance with thermal expansion of the multiple filaments 60, the amount of movement of the movable electrode 72 is calculated using Equation 1, the present invention is not limited to this. The amount of thermal expansion of each of the filaments 60 in accordance with output of the heating power source 81 and heating time (voltage application time) of each of the filaments 60 may be preliminarily measured in an experiment (experimental data) and stored in the storage unit 805. In this case, the drive control unit 802 (FIG. 5) may refer to the corresponding amount of thermal expansion stored in the storage unit 805 in accordance with the output and the heating time of the heating power source 81 during the actual coating treatment, to cause the movable electrode 72 to move in accordance with the corresponding amount of thermal expansion. Additionally, Equation 1 above and the experimental data may be combined to correct the amount of thermal expansion derived from Equation 1 using the experimental data, and movement control of the movable electrode 72, having higher accuracy of the thermal expansion of each of the filaments 60, may be performed.

The present invention provides a hot filament CVD device that performs coating treatment on multiple base materials. The hot filament CVD device includes: a chamber including a chamber body provided with an opening, and a door attached to the chamber body to seal the opening and allow the opening to be openable; multiple filaments disposed inside the chamber to heat a material gas; multiple base material supports insertable into the chamber through the opening in a predetermined insertion direction, the multiple base material supports supporting the corresponding multiple base materials while allowing the multiple base materials to be disposed at intervals in the insertion direction; and a table having a mounting surface on which the multiple base material supports are allowed to be mounted allowing the multiple base materials to be disposed facing the corresponding multiple filaments, and supporting the multiple base material supports inside the chamber while allowing the multiple base material supports to be disposed adjacent to each other in a chamber width direction intersecting the insertion direction.

According to the present configuration, the multiple base material supports supporting the corresponding multiple base materials can be inserted into the chamber through the opening. At this time, the operator can insert the multiple base material supports in the predetermined insertion direction while sliding the base material supports on the mounting surface of the table. Thus, the multiple base materials can be easily disposed at respective coating treatment positions facing the corresponding multiple filaments inside the chamber. The multiple base material supports mounted on the mounting surface are disposed adjacent to each other in the chamber width direction. This enables the multiple base materials to be densely disposed inside the chamber.

The above configuration may be configured such that the table includes a body part having the mounting surface, a standing wall that comes into contact with a leading end in the insertion direction of each of the multiple base material supports mounted on the mounting surface to restrict the multiple base material supports in the insertion direction, and paired side walls that are each brought into contact with a side surface of a corresponding one of paired base material supports located at respective opposite ends of the multiple base material supports mounted on the mounting surface in the chamber width direction, a distance between the paired side walls in the chamber width direction being set to bring the multiple base material supports into contact with each other to restrict the multiple base material supports in the chamber width direction.

According to the present configuration, when the leading ends of the respective multiple base material supports come into contact with the standing wall, the multiple base material supports and also the multiple base materials supported on each of the base material supports are restricted in the insertion direction. When the multiple base material supports are inserted in order, the base material support inserted earlier can guide the adjacent base material support to be inserted later. When all the base material supports are inserted, the multiple base material supports and also the multiple base materials supported on each of the base material supports are restricted in the chamber width direction.

The above configuration may further include a filament holding mechanism that holds the multiple filaments so that the multiple filaments extend in the first direction that is any one of the insertion direction and the chamber width direction and are disposed apart from each other in the second direction that is another of the insertion direction and the chamber width direction, and face the corresponding multiple base materials in a third direction intersecting a plane including the first direction and the second direction inside the chamber.

According to the present configuration, a plane including the multiple filaments is disposed facing the multiple base materials in the third direction. This enables the coating treatment to be applied to the multiple base materials in a wide range.

The above configuration is desirably configured such that the multiple base material supports are each provided with multiple base material holding parts in the insertion direction that hold the corresponding multiple base materials, and the multiple base material holding parts in the respective base material supports are located at respective positions at which the multiple base materials are disposed between the corresponding multiple filaments when viewed from the third direction.

According to the present configuration, when the base materials are held by the respective multiple base material holding parts of each of the base material supports, and the base material supports are supported by the table, the multiple base materials can be easily aligned with the corresponding multiple filaments.

The above configuration desirably further includes a moving mechanism that moves the table in the third direction to move the multiple base materials between a coating treatment position at which the multiple base materials are held close to the corresponding multiple filaments and a separation position at which the multiple base materials are held further apart from the multiple filaments than the coating treatment position in the third direction.

According to the present configuration, when the moving mechanism moves the table in the third direction, the table can be moved between the coating treatment position and the separation position.

## Claims

1. A hot filament CVD device (1) that is configured to perform coating treatment on multiple base materials (5), the hot filament CVD device (1) comprising:

   a chamber (2) including a chamber body (2S) provided with an opening (2H), and a door attached to the chamber body (2S) to seal the opening (2H) and allow the opening (2H) to be openable;
   multiple filaments (60) configured to heat a material gas;
   multiple base material supports (4) insertable into the chamber (2) through the opening (2H) in a predetermined insertion direction (DS), the multiple base material supports (4) configured to support the corresponding multiple base materials (5) while allowing the multiple base materials (5) to be disposed at intervals in the insertion direction (DS); and
   a table (31) having a mounting surface on which the multiple base material supports (4) are allowed to be mounted allowing the multiple base materials (5) to be disposed facing the corresponding multiple filaments (60), and configured to support the multiple base material supports (4) inside the chamber (2) while allowing the multiple base material supports (4) to be disposed adjacent to each other in a chamber width direction intersecting the insertion direction (DS),
   **characterized by**
   a filament cartridge (6A, 6B, 6C) provided with the multiple filaments (60), wherein
   the filament cartridge (6A, 6B, 6C) and the table (31) are disposed inside the chamber (2), and
   the multiple base material supports (4) are insertable into the chamber (2) while sliding the multiple base material supports (4) on the mounting surface of the table (31).

2. The hot filament CVD device (1) according to claim 1, wherein

   the table (31) includes
   a body part (31H) having the mounting surface,
   a standing wall (31T) that comes into contact with a leading end in the insertion direction (DS) of each of the multiple base material supports (4) mounted on the mounting surface to restrict the multiple base material supports (4) in the insertion direction (DS), and
   paired side walls (31R) that are each brought into contact with a side surface of a corresponding one of paired base material supports (4) located at respective opposite ends of the multiple base material supports (4) mounted on the mounting surface in the chamber width direction, a distance between the paired side walls in the chamber width direction being set to bring the multiple base material supports (4) into contact with each other to restrict the multiple base material supports (4) in the chamber width direction.

3. The hot filament CVD device (1) according to claim 1 or 2, wherein
   the filament cartridge (6A, 6B, 6C) includes a filament holding mechanism (61, 62) that holds the multiple filaments (60) so that the multiple filaments (60) extend in the first direction that is any one of the insertion direction (DS) and the chamber width direction and are disposed apart from each other in the second direction that is another of the insertion direction (DS) and the chamber width direction, and face the corresponding multiple base materials (5) in a third direction intersecting a plane including the first direction and the second direction inside the chamber (2).

4. The hot filament CVD device (1) according to claim 3, wherein

   the multiple base material supports (4) are each provided with multiple base material holding parts (4H) in the insertion direction (DS) that hold the corresponding multiple base materials (5), and
   the multiple base material holding parts (4H) in the respective base material supports (4) are located at respective positions at which the multiple base materials (5) are disposed between the corresponding multiple filaments (60) when viewed from the third direction.

5. The hot filament CVD device (1) according to claim 4, further comprising:
   a moving mechanism (83) that moves the table (31) in the third direction to move the multiple base materials (5) between a coating treatment position at which the multiple base materials (5) are held close to the corresponding multiple filaments (60) and a separation position at which the multiple base materials (5) are held further apart from the multiple filaments (60) than the coating treatment position in the third direction.

**Patentansprüche**

1. Heißfilament-CVD-Vorrichtung (1), die so konfiguriert ist, dass sie auf mehreren Grundwerkstoffen (5) eine Beschichtungsbehandlung durchführt, wobei die Heißfilament-CVD-Vorrichtung (1) Folgendes umfasst:

    eine Kammer (2) mit einem Kammerkörper (2S), der mit einer Öffnung (2H) versehen ist, und einer Tür, die an dem Kammerkörper (2S) angebracht ist, um die Öffnung (2H) zu verschließen und der Öffnung (2H) zu ermöglichen, geöffnet zu werden;

    mehrere Filamente (60), die so konfiguriert sind, dass sie ein Werkstoffgas erhitzen;

    mehrere Grundwerkstoffträger (4), die durch die Öffnung (2H) in einer vorbestimmten Einführrichtung (DS) in die Kammer (2) einführbar sind, wobei die mehreren Grundwerkstoffträger (4) so konfiguriert sind, dass sie die entsprechenden mehreren Grundwerkstoffe (5) tragen, während sie den mehreren Grundwerkstoffen (5) ermöglichen, in der Einführrichtung (DS) in Abständen angeordnet zu sein; und

    einen Tisch (31), der eine Montagefläche hat, auf der die mehreren Grundwerkstoffträger (4) montiert werden können, was den mehreren Grundwerkstoffen (5) ermöglicht, so angeordnet zu werden, dass sie den entsprechenden mehreren Filamenten (60) zugewandt sind, und der so konfiguriert ist, dass er die mehreren Grundwerkstoffträger (4) in der Kammer (2) trägt, während er den mehreren Grundwerkstoffträgern (4) ermöglicht, in einer die Einführrichtung (DS) schneidenden Kammerbreitenrichtung nebeneinander angeordnet zu werden, **gekennzeichnet durch**

    eine Filamentkartusche (6A, 6B, 6C) die mit den mehreren Filamenten (60) versehen ist, wobei die Filamentkartusche (6A, 6B, 6C) und der Tisch (31) in der Kammer (2) angeordnet sind und

    die mehreren Grundwerkstoffträger (4) in die Kammer (2) einführbar sind, während die mehreren Grundwerkstoffträger (4) auf der Montagefläche des Tischs (31) verschoben werden.

2. Heißfilament-CVD-Vorrichtung (1) nach Anspruch 1, wobei der Tisch (31) Folgendes aufweist:

    einen Körperteil (31H), der die Montagefläche aufweist,

    eine stehende Wand (31T), die mit einem in der Einführrichtung (DS) vorderen Ende von jedem der mehreren Grundwerkstoffträger (4), die auf der Montagefläche montiert sind, in Kontakt kommt, um die mehreren Grundwerkstoffträger (4) in der Einführrichtung (DS) zu begrenzen, und

    gepaarte Seitenwände (31R), die mit einer Seitenfläche von einem entsprechenden von gepaarten Grundwerkstoffträgern (4), die an jeweils gegenüberliegenden Enden der mehreren Grundwerkstoffträger (4), die in der Kammerbreitenrichtung auf der Montagefläche montiert sind, in Kontakt gebracht werden, wobei ein Abstand zwischen den gepaarten Seitenwänden in der Kammerbreitenrichtung so eingestellt ist, dass er die mehreren Grundwerkstoffträger (4) miteinander in Kontakt bringt, um die mehreren Grundwerkstoffträger (4) in der Kammerbreitenrichtung zu begrenzen.

3. Heißfilament-CVD-Vorrichtung (1) nach Anspruch 1 oder 2, wobei

die Filamentkartusche (6A, 6B, 6C) einen Filamenthaltemechanismus (61, 62) aufweist, der die mehreren Filamente (60) so hält, dass die mehreren Filamente (60) sich in der ersten Richtung erstrecken, die eine von der Einführrichtung (DS) und der Kammerbreitenrichtung ist, und in der zweiten Richtung, die eine andere von der Einführrichtung (DS) und der Kammerbreitenrichtung ist, voneinander beabstandet angeordnet sind und dass sie den entsprechenden mehreren Grundwerkstoffen (5) in der Kammer (2) in einer dritten Richtung zugewandt sind, die eine Ebene schneidet, die die erste Richtung und die zweite Richtung einschließt.

4. Heißfilament-CVD-Vorrichtung (1) nach Anspruch 3, wobei

    die mehreren Grundwerkstoffträger (4) in der Einführrichtung (DS) jeweils mit mehreren Grundwerkstoffhalteteilen (4H) versehen sind, die die entsprechenden mehreren Grundwerkstoffe (5) halten, und

    sich die mehreren Grundwerkstoffhalteteile (4H) in den jeweiligen Grundwerkstoffträgern (4) an jeweiligen Positionen befinden, an denen die mehreren Grundwerkstoffe (4) aus der dritten Richtung gesehen zwischen den entsprechenden mehreren Filamenten (60) angeordnet sind.

5. Heißfilament-CVD-Vorrichtung (1) nach Anspruch 4, die außerdem Folgendes umfasst:
einen Bewegungsmechanismus (83), der den Tisch (31) in der dritten Richtung bewegt, um die mehreren Grundwerkstoffe (5) zwischen einer Beschichtungsbehandlungsposition, an der die mehreren Grundwerkstoffe (5) nahe an den entsprechenden mehreren Filamenten (60) gehalten werden, und einer Trennposition zu bewegen, an der die mehreren Grundwerkstoffe (5) von den mehreren Filamenten (60) in der dritten Richtung weiter als in der Beschichtungsbehandlungsposition entfernt gehalten werden.

**Revendications**

1. Dispositif CVD à filament chaud (1) qui est configuré pour effectuer un traitement de revêtement sur plusieurs matériaux de base (5), le dispositif CVD à filament chaud (1) comprenant :

   une chambre (2) comportant un corps de chambre (2S) pourvu d'une ouverture (2H), et une porte fixée au corps de chambre (2S) pour sceller l'ouverture (2H) et permettre à l'ouverture (2H) de s'ouvrir ;
   de multiples filaments (60) configurés pour chauffer un gaz de matériau ;
   de multiples supports de matériaux de base (4) insérables dans la chambre (2) à travers l'ouverture (2H) dans une direction d'insertion prédéterminée (DS), les multiples supports de matériaux de base (4) configurés pour soutenir les multiples matériaux de base correspondants (5) tout en permettant aux multiples matériaux de base (5) d'être disposés à intervalles dans la direction d'insertion (DS) ; et
   une table (31) ayant une surface de montage sur laquelle les multiples supports de matériaux de base (4) peuvent être montés, permettant aux multiples matériaux de base (5) d'être disposés face aux multiples filaments (60) correspondants, et configurée pour soutenir les multiples supports de matériaux de base (4) à l'intérieur de la chambre (2) tout en permettant aux multiples supports de matériaux de base (4) d'être disposés de façon adjacente dans une direction de largeur de la chambre coupant la direction d'insertion (DS),
   **caractérisé par**
   une cartouche de filaments (6A, 6B, 6C) pourvue de plusieurs filaments (60), dans lequel
   la cartouche de filaments (6A, 6B, 6C) et la table (31) sont disposées à l'intérieur de la chambre (2), et
   les supports de matériaux de base multiples (4) peuvent être insérés dans la chambre (2) tout en faisant glisser les supports de matériaux de base multiples (4) sur la surface de montage de la table (31).

2. Dispositif CVD à filament chaud (1) selon la revendication 1, dans lequel

   la table (31) comporte
   une partie du corps (31H) ayant la surface de montage,
   une paroi debout (31T) qui entre en contact avec une extrémité avant dans la direction d'insertion (DS) de chacun des multiples supports de matériau de base (4) montés sur la surface de montage pour restreindre les multiples supports de matériau de base (4) dans la direction d'insertion (DS), et
   des parois latérales appariées (31R) qui sont chacune mises en contact avec une surface latérale d'un correspondant des supports de matériau de base appariés (4) situés aux extrémités opposées respectives des supports de matériau de base multiples (4) montés sur la surface de montage dans la direction de la largeur de la chambre, une distance entre les parois latérales appariées dans la direction de la largeur de la chambre étant réglée pour mettre les supports de matériau de base multiples (4) en contact les uns avec les autres afin de restreindre les supports de matériau de base multiples (4) dans la direction de la largeur de la chambre.

3. Dispositif CVD à filament chaud (1) selon la revendication 1 ou 2, dans lequel
   la cartouche de filaments (6A, 6B, 6C) comporte un mécanisme de maintien des filaments (61, 62) qui maintient les multiples filaments (60) de sorte que les multiples filaments (60) s'étendent dans la première direction qui est l'une quelconque de la direction d'insertion (DS) et de la direction de la largeur de la chambre et sont éloignés les uns des autres dans la deuxième direction qui est une autre de la direction d'insertion (DS) et de la direction de la largeur de la chambre, et font face aux multiples matériaux de base correspondants (5) dans une troisième direction coupant un plan comprenant la première direction et la deuxième direction à l'intérieur de la chambre (2).

4. Dispositif CVD à filament chaud (1) selon la revendication 3, dans lequel

   les multiples supports de matériau de base (4) sont chacun pourvus de multiples pièces de maintien de matériau de base (4H) dans la direction d'insertion (DS) qui maintiennent les multiples matériaux de base correspondants (5), et
   les multiples pièces de maintien du matériau de base (4H) dans les supports de matériau de base respectifs (4) sont situées à des positions respectives auxquelles les multiples matériaux de base (5) sont disposés entre les multiples filaments correspondants (60) lorsqu'ils sont vus de la troisième direction.

5. Dispositif CVD à filament chaud (1) selon la revendication 4, comprenant en outre :
un mécanisme de déplacement (83) qui déplace la table (31) dans la troisième direction pour déplacer les multiples matériaux de base (5) entre une position de traitement de revêtement dans laquelle les multiples matériaux de base (5) sont maintenus à proximité des multiples filaments (60) correspondants et une position de séparation dans laquelle les multiples matériaux de base (5) sont maintenus plus éloignés des multiples filaments (60) que la position de traitement de revêtement dans la troisième direction.

# FIG.1

# FIG.2

# FIG.3

# FIG.4

# FIG.5

80  
CONTROL UNIT

801  
POWER SOURCE CONTROL UNIT

81  
HEATING POWER SOURCE

802  
DRIVE CONTROL UNIT

82  
ELECTRODE DRIVE UNIT

803  
CALCULATION UNIT

804  
DETERMINATION UNIT

83  
STAGE DRIVE UNIT

805  
STORAGE UNIT

84  
OPERATION UNIT

806  
OUTPUT UNIT

85  
DISPLAY

# FIG.6

FIG.7

# FIG.8

UP

LEFT ← → RIGHT

DOWN

633       63H

632A      632

631A  631B

631

# FIG.9

UP

LEFT ←——→ RIGHT

DOWN

# FIG.10

# FIG.11

# FIG.12

UP

LEFT ← → RIGHT

DOWN

732

71

71J1

71J2

71J

71H

71K

71K1

71K2

# FIG.13

# FIG.14

# FIG.15

REAR

LEFT ←→ RIGHT

FRONT

# FIG.16

EP 3 831 979 B1

# FIG.17

UP

LEFT — REAR

FRONT — RIGHT

DOWN

# FIG.18

**EP 3 831 979 B1**

**REFERENCES CITED IN THE DESCRIPTION**

**Patent documents cited in the description**

- JP H046274 A

- CN 106167894 A